# EUROPÄISCHE PATENTSCHRIFT

(11) **EP 1 871 158 B1**
(45) Veröffentlichungstag und Bekanntmachung des Hinweises auf die Patenterteilung: **22.12.2010**
(21) Anmeldenummer: 07109092.2
(22) Anmeldetag: 29.05.2007
(51) Int. Cl.: H05K 13/04

(54) **Pipette und System aus Pipette und Segment für einen Bestückautomaten**
Pipette and system consisting of pipette and segment for a mounting machine
Pipette et système à pipette et segment pour un automate d'implantation

(30) Priorität: 22.06.2006 DE 102006028676
(43) Veröffentlichungstag der Anmeldung: 26.12.2007
(73) Patentinhaber: Siemens Electronics Assembly Systems GmbH & Co. KG, 81379 München (DE)
(72) Erfinder: Schmid, Rudolf, 82223 Eichenau (DE); Trigiani, Michele, 81373 München (DE)

(56) Entgegenhaltungen:
- WO-A-01/35711
- JP-A- 4 133 400
- US-A- 5 758 410

## Beschreibung

Die Erfindung bezieht sich auf eine Pipette für einen Bestückautomaten gemäß dem Oberbegriff des Patentanspruchs 1 und ein System aus einer Pipette und einem Segment für einen Bestückautomaten gemäß dem Oberbegriff des Patentanspruchs 6.

In Bestückautomaten werden Bauelemente von Bestückköpfen aus Zuführeinheiten entnommen und anschließend lagerichtig auf vordefinierten Positionen auf Substrate aufgesetzt. Zum Aufnehmen der Bauelemente dienen Pipetten, die mit Saugluft beaufschlagt werden und so die Bauelemente ansaugen und damit während des Transports von den Zuführeinheiten zum Substrat festhalten. Damit unterschiedlich große und unterschiedlich geformte Bauelemente gehalten werden können, werden im Bestückautomaten in einem Pipettenmagazin Pipetten mit verschiedenen Saugquerschnitten, Saugauslassöffnungen und Größen vorrätig gehalten, die im Laufe eines Bestückprozesses austauschbar sind. Dazu werden an die so genannten Segmente des Bestückkopfes die jeweils gewünschten Pipetten in deren axialen Längsrichtung angesteckt und gegebenenfalls bei geänderten Bauelementgeometrien oder weil die Pipette schadhaft ist, ausgewechselt.

Bisher sind durch die WO01/35711 A2 Pipetten bekannt, die einen Rastwulst an einem Innendurchmesser eines rohrförmigen Anschluss-Stücks der Pipette aufweisen. Das Segment als Gegenstück besitzt Höcker in Form von Kugeln, die in einen Zylinder eingebettet sind. Die Kugeln ragen etwas über die Zylinderfläche nach außen. Die Pipette rastet beim Aufstecken mit dem Rastwulst über die Kugeln und wird dabei gegen eine segmentseitige Stirnfläche gedrückt, damit die Position der Pipette in Richtung senkrecht zum Substrat (z-Richtung) genau bekannt ist.

Aus US2002/0032960 A1 ist beispielsweise ebenfalls ein System Pipette-Segment bekannt, bei dem die Pipette an einem rohrförmigen Anschluss-Stück eine Nut aufweist, die mit Federn zusammenwirkt, die am Segment befestigt sind.

Beim Rasten wird die Pipette dabei aufgeweitet und verformt. Der Rastdurchmesser muss dabei sehr genau gefertigt werden, um die nötigen Rastkräfte zu gewährleisten. Das System ist sehr steif und kleine Maßabweichungen bewirken große Veränderungen der Rastkraft. Außerdem verformt sich die Pipette beim Rasten (aus einem nominell kreisförmigen Querschnitt wird beim Rasten über die Kugeln ein "Dreieck"), und damit ändert sich auch der Zentrierdurchmesser der Pipette, der zur Zentrierung der Pipette in einer Ebene parallel zum Substrat (x-y-Ebene) und damit senkrecht zu einer Pipettenachse (in z-Richtung) genutzt wird. Dadurch klemmt die Pipette und wird schwergängig, was zu hohen Abzugskräften führt.

Ferner ist nach der US5758410 A eine Pipette mit stirnseitig von einem Zentrierabschnitt vorstehenden Rastfingern versehen, die in entsprechende Rastvertiefungen eines Pipettenhalters eingreifen. Die Pipette umgreift mit dem Zentrierabschnitt einen zylindrischen Abschnitt des Pipettenhalters und ist somit gegen seitlichen Versatz zentriert. Dies ergibt eine große Gesamtlänge der Zentrier- und Haltemittel, was beim Pipettenwechsel einen entsprechend großen Montagehub des Pipettenhalters in der Achsrichtung der Pipette erfordert.

Es ist daher die Aufgabe der Erfindung eine möglichst kurze Pipette, ein Segment und ein System aus Pipette und Segment anzugeben, welche die Anzahl der Wechselzyklen, die Pipette und Segment aushalten, erhöht und weniger stark schwankende Abzugskräfte sicherstellt.

Die Aufgabe wird erfindungsgemäß durch eine Pipette der eingangs genannten Art mit den kennzeichnenden Merkmalen des Anspruchs 1 und ein System aus Pipette und Segment der eingangs genannten Art mit den kennzeichnenden Merkmalen des Anspruchs 6 gelöst.

Dabei wird durch die getrennte Ausführung der pipettenseitigen Zentriermittel und der pipettenseitigen Verbindungsmittel im gleichen Längenabschnitt der Pipette sichergestellt, dass bei kurzer Aufstecklänge die Funktionen Pipettensitz bzw. Zentrierung (also x-, y- und gegebenenfalls zusätzlich z-Genauigkeit) und Pipettenhalt bzw. Verbindung getrennt sind und entkoppelt sind, indem die z.B. die Verbindungsmittel im Bereich der Zentriermittel über deren Umfang verteilt angeordnet sind. Dadurch lassen sich die beiden Funktionen jede für sich optimieren und beeinflussen sich nicht mehr gegenseitig. Es können höhere Wechselzyklen, konstante Abzugskräfte und konstante Rastkräfte erreicht werden und gleichzeitig werden die Anforderungen an die Herstellung reduziert, denn Toleranzen werden aufgeweitet und es werden geringere Anforderungen an das Material gestellt.

Ein sehr gute Zentrierung lässt sich gemäß der Pipette nach Anspruch 2 dadurch erreichen, dass die pipettenseitigen Zentriermittel als rohrförmiges Anschluss-Stück ausgebildet sind, dessen genau gefertigter Innendurchmesser die Zentrierung in einer Ebene senkrecht zur Achse des Anschluss-Stücks sicherstellt.

Eine bevorzugte Ausgestaltung der Pipette nach Anspruch 3 ergibt sich dadurch, dass die pipettenseitigen Zentriermittel als an der Innenseite eines rohrförmigen Anschluss-Stücks in Achsrichtung angeordnete Stege ausgebildet sind. Dadurch wird eine Zentrierung zum Segment nur über die Stege erreicht, was zu einer geringeren Reibung zwischen Pipette und Segment führt und damit zu genauer einzuhaltenden Abzugskräften.

Durch die Pipette gemäß Anspruch 1 mit gefedert gelagerten, radial auslenkbaren Kugeln als pipettenseitige Verbindungsmittel wird eine gute Verbindung erreicht.

Bei der Ausgestaltung nach Anspruch 4 werden in vorteilhafter Weise drei Kugeln verwendet, die in gleichem Abstand entlang einer Innenwand der Pipette angeordnet sind. Durch die Verwendung von zumindest drei Kugeln entsteht bei geringem Materialaufwand eine sichere Rastung.

Ein Federring gemäß Anspruch 5 zur Federung der Kugeln führt in vorteilhafter Weise zu einer einfachen Herstellung der Federung.

Im Folgenden wird die Erfindung durch Ausführungsbeispiele anhand der Figuren der Zeichnung näher erläutert.

### Dabei zeigen

Figur 1a schematisch einen seitlichen Querschnitt durch ein erstes Ausführungsbeispiel des erfindungsgemäßen Systems Pipette-Segment,
Figur 1b schematisch einen Querschnitt entlang der Schnittlinie A-A' der Figur 1a,
Figur 2a schematisch einen seitlichen Querschnitt durch ein zweites Ausführungsbeispiel des erfindungsgemäßen Systems Pipette-Segment und
Figur 2b schematisch einen Querschnitt entlang der Schnittlinie B-B' der Figur 2a.

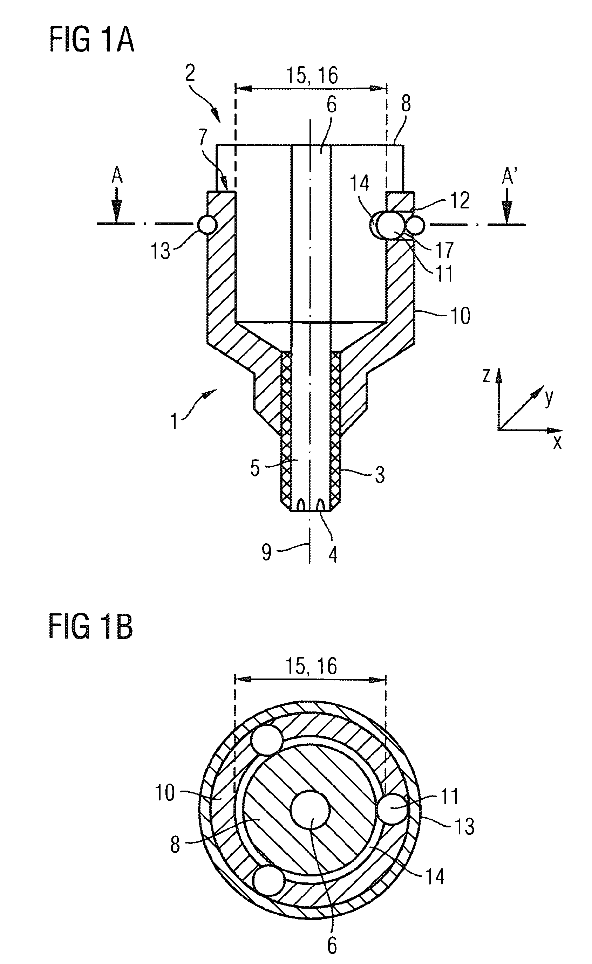

In Figur 1a ist schematisch eine Pipette 1 im Querschnitt gezeigt, die an ein Segment 2 eines nicht vollständig dargestellten Bestückkopfes eingerastet ist. In Figur 1b ist dazu ein Querschnitt entlang der Schnittlinie A-A' der Figur 1a gezeigt. Die Pipette 1 ist im wesentlichen symmetrisch um eine Achse 9 aufgebaut und beinhaltet eine Pipettenspitze 3, die beispielsweise aus einem keramischen Material hergestellt ist, die auf ihrer einem Bauelement zugewandten Seite Öffnungen 4 aufweist, durch die ein Unterdruck zum Ansaugen der Bauelemente beaufschlagt werden kann. Dazu dient ein Pipettenkanal 5, der sich im aufgesteckten Zustand an einen Segmentkanal 6 anschließt, der mit einer - nicht dargestellten - Vakuumversorgung des Bestückautomaten verbunden ist. Die Pipette 1 weist ein rohrförmiges Anschluss-Stück 10 auf, welches mit seinem Innendurchmesser 15 passgenau auf einen Außendurchmesser 16 eines Segmentzylinders 8 des Segments 2 passt. Durch die Abstimmung der beiden Durchmesser 15, 16 ist eine gute Zentrierung in einer Ebene parallel zum zu bestückenden Substrat (x-y-Ebene) zu erzielen.

Die Rastung erfolgt durch drei als Kugeln 11 ausgebildete Rastelemente, die sich in jeweils einem Ausbruch 12 befinden, der in eine Pipettenmantelfläche eingearbeitet ist. Die Kugeln 11 werden von außen eingebracht und liegen mit leichtem Spiel in den Ausbrüchen 12. Die Ausbrüche 12 sind so gestaltet, dass die Kugeln 11 nicht in das Innere der Pipette 1 fallen können. Außen sind die Ausbrüche 12 mit einem vorgespannten Federring 13, beispielsweise aus Stahl, abgedeckt, der seinerseits in einer Nut 17 geführt wird.

Wird nun die Pipette 1 auf das Segment 2 gesteckt, werden die Kugeln 11 nach außen gegen den Federring 13 gedrückt. Der Federring 13 gibt nach und überträgt seine Vorspannung auf die Kugeln 11. Die Kugeln 11 rasten in eine Nut 14 (V-Nut) im Segment 2 und drücken die Pipette 1 gleichzeitig gegen eine segmentseitige Anlagefläche 7, wodurch ein genauer Sitz in z-Richtung senkrecht zur Substratfläche erzielt wird.

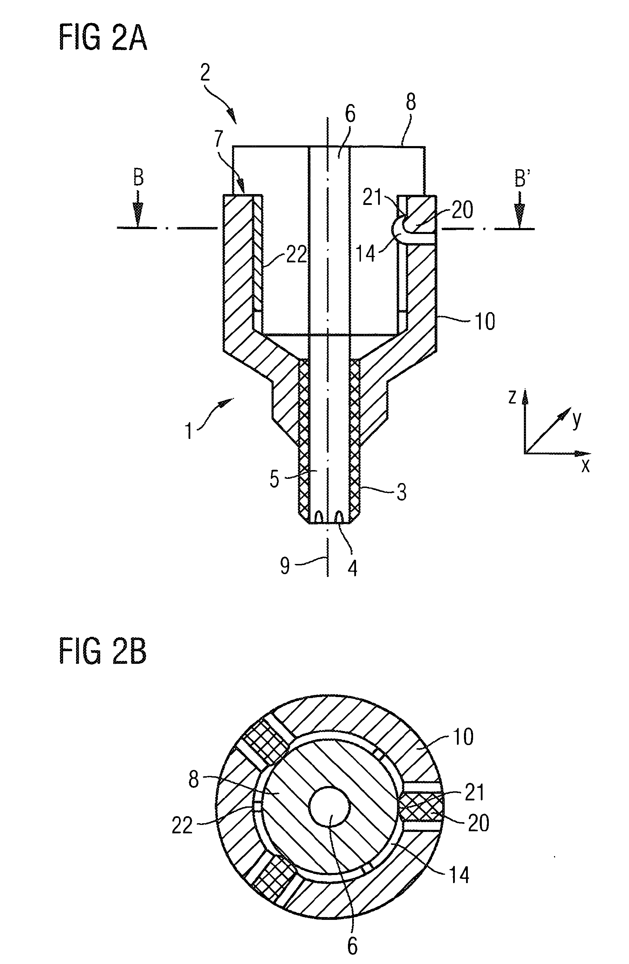

Im in Figur 2a und 2b dargestellten zweiten Ausführungsbeispiel ist ebenfalls ein System Pipette-Segment dargestellt, wobei gleiche Teile gleiche Bezugszeichen aufweisen. Die Rastung erfolgt hierbei durch drei als Lappen 20 ausgebildete Restelemente mit jeweils einem Rastwulst 21. Die Lappen 20 werden beim Aufstecken der Pipette 1 auf das Segment 2 vorgespannt. Der Rastwulst 21 rastet in die V-Nut 14 des Segments 2. Bei diesem zweiten Ausführungsbeispiel müssen keine Kugeln oder Federringe montiert werden.

Im zweiten Ausführungsbeispiel sind zusätzlich insgesamt drei Stege 22 vorgesehen, die in z-Richtung an der Innenseite des Anschluss-Stücks 10 ausgebildet sind und im aufgesteckten Zustand den Kontakt zum Außendurchmesser 16 des Segmentzylinders 8 des Segments 2 für die Zentrierung realisieren. Dadurch liegen nur drei Punkte am Umfang auf, über welche die Zentrierung gewährleistet ist. So können geringfügige Schrumpfungserscheinungen ausgeglichen werden, indem sich der Querschnitt von "rund" auf "dreieckig" verformt, ohne dass die Pipette im Zentriersitz klemmt. Selbstverständlich lassen sich die Stege 22 auch mit dem ersten Ausführungsbeispiel der gefedert gelagerten Kugeln 11 kombinieren.

Beide Ausführungsbeispiele haben den Vorteil, dass der Innen- und damit Zentrierdurchmesser 15 in der Pipette 1 beim Rasten nicht beeinflusst wird. Die Abzugskraft hängt im Wesentlichen nur von den Rastelementen, also den Lappen 20, der Rastwulst 21, der V-Nut 14, bzw. den Kugeln 11 und dem Federring 13 und deren Steifigkeit bzw. Vorspannung ab. Die Steifigkeit der Verbindungselemente oder Rastelemente ist deutlich geringer als die Steifigkeit der eigentlichen Pipette 1.

Durch die Funktionstrennung Zentrierung und Verbindung lässt sich das System Pipette 1 - Segment 2 gezielt verbessern, was zu höheren Wechselzyklen, konstanten Abzugskräften und konstanten Rastkräften führt.

## Patentansprüche

1. Pipette (1) für einen Bestückautomaten, die zum Verbinden mit einem Segment (2) eines Bestückkopfes des Bestückautomaten geeignet ist,
mit pipettenseitigen Verbindungsmitteln (11, 13, 20, 21) zum aufsteckbaren Verbinden der Pipette (1) mit dem Segment (2) im verbundenen Zustand und mit
pipettenseitigen Zentriermitteln (10, 15, 22) zum Zentrieren der Pipette (1) gegenüber dem Segment (2) im verbundenen Zustand,
wobei
die pipettenseitigen Verbindungsmittel (11, 13, 20, 21) getrennt von den pipettenseitigen Zentriermitteln (10, 22) ausgebildet sind und wobei
die pipettenseitigen Verbindungsmittel (11, 13, 20, 21) radial federnd auslenkbare Rastelemente (11, 21) aufweisen,
**dadurch gekennzeichnet, dass**
die Rastelemente (11, 21) und die Zentriermittel (10, 22) innerhalb eines gemeinsamen Längsabschnittes der Pipette angeordnet sind und
die pipettenseitigen Verbindungsmittel als gefedert gelagerte Kugeln (11) ausgebildet sind.

2. Pipette (1) nach Anspruch 1,
**dadurch gekennzeichnet, dass**
die pipettenseitigen Zentriermittel (10, 15) als rohrförmiges Anschluss-Stück (10) ausgebildet sind, dessen genau gefertigter Innendurchmesser (15) die Zentrierung in einer Ebene (x-y) senkrecht zur Achse (9) des Anschluss-Stücks (10) sicherstellt.

3. Pipette (1) nach Anspruch 1,
**dadurch gekennzeichnet, dass**
die pipettenseitigen Zentriermittel als an der Innenseite eines rohrförmigen Anschluss-Stücks (10) in Achsrichtung (9) angeordnete Stege (22) ausgebildet sind.

4. Pipette (1) nach einem der Ansprüche 1 bis 3,
**dadurch gekennzeichnet, dass**
drei in gleichem Abstand entlang einer Innenwand der Pipette angeordnete gefedert gelagerte Kugeln (11) die Verbindungsmittel darstellen.

5. Pipette (1) nach einem der Ansprüche 1 bis 4,
**dadurch gekennzeichnet, dass** die Kugeln (11) durch einen Federring (13) gefedert sind, der in einer Nut (17) der Pipette umläuft.

6. System aus Pipette (1) und Segment (2) für einen Bestückautomaten, mit
pipettenseitigen Verbindungsmittel (11, 13, 20, 21) und segmentseitigen Verbindungsmitteln (14), die im verbundenen Zustand die Verbindung zwischen der Pipette (1) und dem Segment (2) sicherstellen und mit
pipettenseitigen Zentriermitteln (10, 22) und mit segmentseitigen Zentriermitteln (16), die im verbundenen Zustand eine Zentrierung der Pipette (1) zumindest in einer Ebene (x-y) senkrecht zu einer Hauptachse des Systems sicherstellen,
wobei
die pipettenseitigen Verbindungsmittel (11, 13, 20, 21) getrennt von den pipettenseitigen Zentriermitteln (10, 22) ausgebildet sind,
**dadurch gekennzeichnet, dass**
die pipettenseitigen Verbindungsmittel als gefedert gelagerte Kugeln (11) und die segmentseitigen Verbindungsmittel als umlaufende Nut (14) ausgebildet sind.

7. System nach Anspruch 6,
**dadurch gekennzeichnet, dass**
die Kugeln (11) entlang einer Innenwand der Pipette angeordnet sind und durch einen Federring (13) gefedert sind, der in einer Nut (17) der Pipette umläuft.

## Claims

1. Pipette (1) for a mounting machine which is suitable for connection to a segment (2) of a mounting head of the automatic component mounting machine,
with pipette-side connection means (11, 13, 20, 21) for push-on connection of the pipette (1) to the segment (2) in the connected state and with
pipette-side centering means (10, 15, 22) for centering the pipette (1) in relation to the segment (2) in the connected state,
whereby
the pipette-side connection means (11, 13, 20, 21) are embodied separately from the pipette-side centering means (10, 15, 22) and whereby
the pipette-side connection means (11, 13, 20, 21) have radially sprung deflectable latching elements (11, 21), **characterised in that**
the latching elements (11, 21) and the centering means (10, 22) are arranged within a common longitudinal section of the pipette and
the pipette-side connection means are embodied as spring-loaded balls (11)

2. Pipette (1) according to claim 1,
**characterised in that**
the pipette-side centering means (10, 15) are embodied as a tubular connecting piece (10), the precisely-made inner diameter (15) of which ensures centering in a plane (x-y) perpendicular to the axis (9) of the connecting piece (10).

3. Pipette (1) according to claim 1,
**characterised in that**
the pipette-side centering means are embodied as bars (22) arranged on the inner side of a tubular connecting piece (10) in the axial direction (9).

4. Pipette (1) according to one of claims 1 to 3,
**characterised in that**
three spring-loaded balls (11) arranged equidistantly from each other along the inner wall of the pipette represent the connection means.

5. Pipette (1) according to one of claims 1 to 4,
**characterised in that** the balls (11) are spring-loaded by a spring ring (13) running around a groove (17) of the pipette.

6. System consisting of pipette (1) and segment (2) for an automatic component mounting machine, with
pipette-side connection means (11, 13, 20, 21) and segment-side connection means (14), which in the connected state ensure the connection between the pipette (1) and the segment (2), and with
pipette-side centering means (10, 22) and with segment-side centering means (16) which, in the connected state, ensure centering of the pipette (1) at least in one plane (x-y) perpendicular to a main axis of the system,
whereby
the pipette-side connection means (11, 13, 20, 21) are embodied separately from the pipette-side centering means (10, 22),
**characterised in that**
the pipette-side connection means are embodied as spring-loaded balls (11) and the segment-side connection means as a circumferential groove (14).

7. The system according to claim 6,
**characterised in that**
the balls (11) are arranged along an inner wall of the pipette and are sprung by means of a spring ring (13) running in a groove (17) around the pipette.

## Revendications

1. Pipette (1) pour une machine d'insertion automatique qui est adaptée pour être reliée à un segment (2) d'une tête d'insertion de la machine d'insertion automatique,
comprenant des moyens de liaison côté pipette (11, 13, 20, 21), destinés à une liaison par emboîtement de la pipette (1) avec le segment (1) à l'état relié et comprenant
des moyens de centrage côté pipette (10, 15, 22) pour le centrage de la pipette (1) par rapport au segment (2) à l'état relié,
les moyens de liaison côté pipette (11, 13, 20, 21) étant exécutés de manière séparée des moyens de centrage côté pipette (10, 22) et
les moyens de liaison côté pipette (11, 13, 20, 21) comprenant des éléments d'encliquetage (11, 21) pouvant subir une déviation élastique dans le sens radial,
**caractérisée en ce que**
les éléments d'encliquetage (11, 21) et les moyens de centrage (10, 22) sont situés à l'intérieur d'une section longitudinale commune de la pipette et
les moyens de liaison côté pipette sont exécutés en tant que billes (11) montées élastiquement.

2. Pipette (1) selon la revendication 1, **caractérisée en ce que** les moyens de centrage côté pipette (10, 15) sont exécutés en tant que pièce de raccordement tubulaire (10) dont le diamètre intérieur (15) réalisé avec précision garantit le centrage dans un plan (x-y) perpendiculaire à l'axe (9) de la pièce de raccordement (10).

3. Pipette (1) selon la revendication 1, **caractérisée en ce que** les moyens de centrage côté pipette sont exécutés en tant qu'âmes (22) situées sur le côté intérieur d'une pièce de raccordement tubulaire (10) dans la direction axiale (9).

4. Pipette (1) selon l'une des revendications 1 à 3, **caractérisée en ce que** trois billes (11) montées élastiquement le long d'une paroi intérieure de la pipette représentent les moyens de liaison.

5. Pipette (1) selon l'une des revendications 1 à 4, **caractérisée en ce que** les billes (11) sont soumises à l'action élastique d'une rondelle élastique (13) qui s'étend de manière périphérique dans une rainure (17) de la pipette.

6. Système de pipette (1) et de segment (2) pour une machine d'insertion automatique, comprenant des moyens de liaison côté pipette (11, 13, 20, 21) et des moyens de liaison côté segment (14) qui, à l'état relié, assurent la liaison entre la pipette (1) et le segment (2) et comprenant
des moyens de centrage côté pipette (10, 22) et des moyens de centrage côté segment (16) qui, à l'état relié, assurent un centrage de la pipette (1) au moins dans un plan (x-y) perpendiculaire à un axe principal du système,
les moyens de liaison côté pipette (11, 13, 20, 21) étant exécutés de manière séparée des moyens de centrage côté pipette (10, 22),
**caractérisé en ce que**
les moyens de liaison côté pipette (11, 13, 20, 21) sont exécutés en tant que billes (11) montées élastiquement et les moyens de liaison côté segment en tant que rainure périphérique (14).

7. Système selon la revendication 6,
**caractérisé en ce que** les billes (11) sont situées le long d'une paroi intérieure de la pipette et sont soumises à l'action élastique d'une rondelle élastique (13) qui s'étend de manière périphérique dans une rainure (17) de la pipette.
